# EUROPEAN PATENT APPLICATION

(11) **EP 2 485 263 A1**
(43) Date of publication of application: **08.08.2012**
(21) Application number: 10818931.7
(22) Date of filing: 28.09.2010
(51) Int. Cl.: H01L 31/04

(54) **SOLAR CELL ELEMENT AND METHOD OF MANUFACTURE THEREOF**

(30) Priority: 28.09.2009 JP 2009222820
(71) Applicant: Kyocera Corporation, Kyoto-shi, Kyoto 612-8501 (JP)
(72) Inventor: MIURA, Yoshio, Higashiomi-shi Shiga 527-8555 (JP)
(74) Representative: Witte, Weller & Partner
(86) International application number: PCT/JP2010/066845
(87) International publication number: WO 2011/037261

(57) **Abstract**

[Problem] In an element, there is a tendency that an incident light multiple-reflected from a back surface or from an adjacent element has its intensity increased in an outer edge of the element. Therefore, a current occurring per unit area is larger in a peripheral portion of a solar cell element than in a central portion thereof. This causes a problem that a current extremely concentrates in a certain electrode on the solar cell element while making it difficult that the current goes to the other electrodes, which consequently increases a series resistance of the whole of the element.

[Solution] A solar cell element comprises a semiconductor substrate with a first surface serving as a light-receiving surface, a second surface that is a back surface of the first surface, and a plurality of through holes formed so as to extend from the first surface to the second surface. An area of an opening of each of the plurality of through holes increases as the through hole is located closer to a peripheral portion of the semiconductor substrate relative to a central portion thereof.

## Description

### TECHNICAL FIELD

The present invention relates to a solar cell element and a method for manufacturing the same.

### BACKGROUND ART

In recent years, along with growing concerns about energy issues and environmental issues, an increasing attention has been paid to photovoltaic power generation using a solar cell element for converting light energy directly into electric energy. The market is demanding a more efficient and inexpensive solar cell element. Therefore, a back contact solar cell element has been proposed in which light-receiving surface electrodes are partially or wholly arranged on a non-light-receiving surface (back surface), in order to increase a photo current.

Examples of the back contact solar cell element include a through-hole type back contact solar cell in which a semiconductor substrate such as a silicon substrate includes through holes formed at a plurality of predetermined positions thereof and a conductive member is loaded in the through holes so that electrodes on a light-receiving surface and electrodes on a back surface are connected to each other.

For forming the through holes in such a through-hole type back contact solar cell, for example, a method using a YAG laser or an etching process has been proposed (see Patent Documents 1 and 2).

Additionally, for example, there is a disclosure concerning the through holes being inclined with respect to a main surface in a through-hole type back contact solar cell (see Patent Documents 3 and 4).

### PRIOR-ART DOCUMENTS

### PATENT DOCUMENTS

Patent Document 1: Japanese Patent Application Laid-Open No. 5-82811 (1993)
Patent Document 2: Japanese Patent Application Laid-Open No. 6-181323 (1993)
Patent Document 3: Japanese Patent Application Laid-Open No. 2009-76512
Patent Document 4: Japanese Patent Application Laid-Open No. 4-107881 (1992)

### SUMMARY OF THE INVENTION

### PROBLEMS TO BE SOLVED BY THE INVENTION

Here, in a solar cell element, generally, it is likely that a current occurring per unit area is larger in a peripheral portion of the solar cell element than in a central portion thereof, because of an incident light multiple-reflected from other solar cell elements.

Therefore, in the through-hole type back contact solar cells as disclosed in the Patent Documents 1 to 4, similarly to the general solar cell module, a current extremely concentrates in electrodes closer to a peripheral portion of the solar cell element 1 to make it difficult that the current flows in the other electrodes. Therefore, a series resistance tends to rise in the whole of the solar cell element.

### MEANS FOR SOLVING THE PROBLEMS

In view of the above, a solar cell element of the present invention is a solar cell element comprising a semiconductor substrate with a first surface serving as a light-receiving surface, a second surface that is a back surface of the first surface, and a plurality of through holes formed so as to extend from the first surface to the second surface, wherein an area of an opening of each of the plurality of through holes increases as the through hole is located closer to a peripheral portion of the semiconductor substrate relative to a central portion thereof.

A solar cell module of the present invention includes the solar cell element.

A method for manufacturing a solar cell element includes forming the plurality of through holes by irradiating the semiconductor substrate with a laser from a specific position while varying an angle of the irradiation.

### EFFECTS OF THE INVENTION

In view of the above, in the present invention, an opening of each of the through holes is made larger as the through hole is located closer to an outer edge of the element, thereby substantially reducing a difference in the resistance among the through holes. That is, current densities in the electrodes in the central portion and in the peripheral portion can be made uniform. This can reduce a series resistance component of the entire solar cell element, and thus improve a photoelectric conversion efficiency.

### BRIEF DESCRIPTION OF THE DRAWINGS

[FIG. 1] A plan view showing an entire solar cell element of the present invention, in which (a) is a plan view showing an embodiment of a second surface (non-light-receiving surface) of the solar cell element according to the present invention, and (b) is a plan view showing an embodiment of the shape of electrodes formed on a corresponding first surface (light-receiving surface).
[FIG. 2] An enlarged cross-sectional view of a part of the solar cell element shown in FIG. 1, in which (a) is an enlarged cross-sectional view of a part as taken along the like X-X of FIG. 1, and (b) is an enlarged cross-sectional view of a part as taken along the line Y-Y of FIG. 1.
[FIG. 3] A diagram for illustrating a manufacturing method for forming through holes in a semiconductor substrate, in which (a) is a cross-sectional view as taken along the line X'-X' of FIG. 1, (b) is a cross-sectional view as taken along the line Y'-Y' of FIG. 1, and (c) is a partial enlarged view of FIG. 1(b).
[FIG. 4] A schematic cross-sectional view for explaining a current density in the solar cell element of the present invention.
[FIG. 5] A schematic view for illustrating a configuration of a laser apparatus for forming the through holes in the semiconductor substrate.
[FIG. 6] A schematic cross-sectional view for explaining multiple-reflection in a solar cell module.

### EMBODIMENT FOR CARRYING OUT THE INVENTION

### «Solar Cell Element»

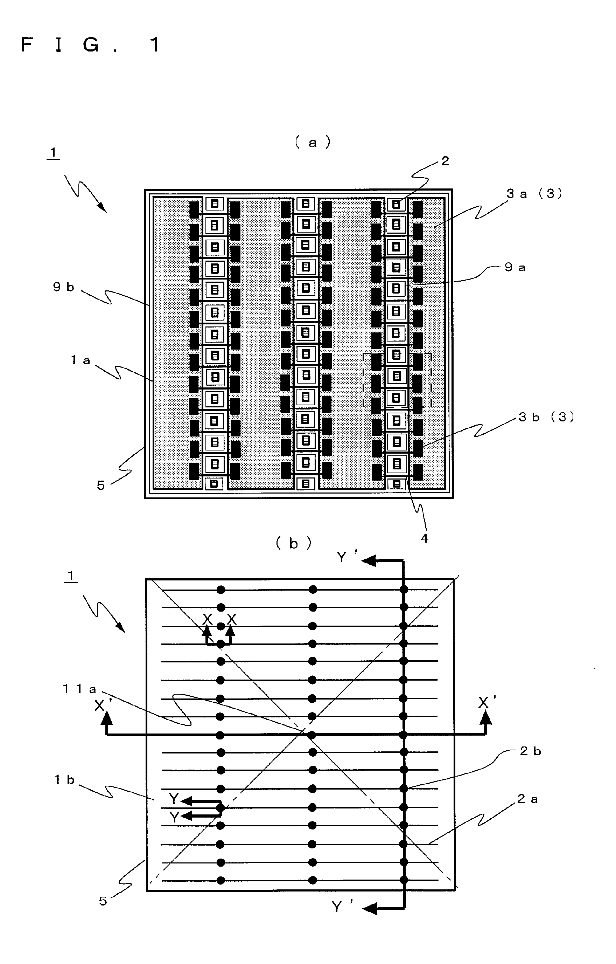

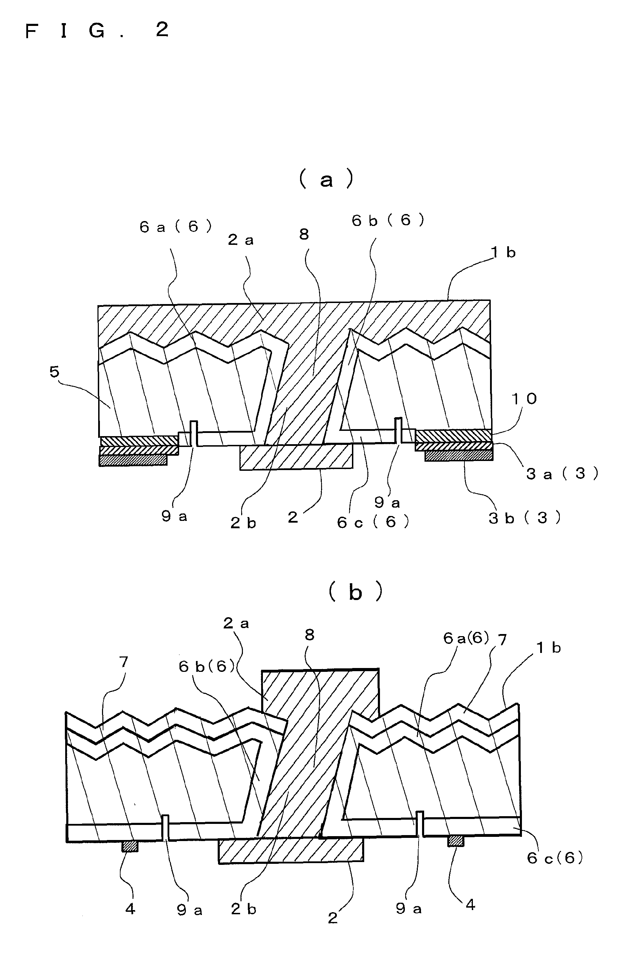

A solar cell element 1 according to the present invention will be described with reference to FIG. 1 and FIG. 2 that shows an enlarged cross-sectional view of a part of the solar cell element 1 shown in FIG. 1.

The solar cell element 1 of the present invention comprises a semiconductor substrate 5 including a first surface 1b for receiving sunlight, and a second surface 1a located at the back side thereof, and a plurality of through holes 8 formed through between the first surface 1b and the second surface 1a. A conductive load material is loaded in the through holes 8, thus forming through hole electrodes 2b.

As shown in FIG. 1(b), light-receiving surface electrodes 2a formed on the first surface 1b of the semiconductor substrate 5 are a plurality of fine-straight-line electrodes arranged substantially at regular intervals. Furthermore, about three through hole electrodes 2b are connected onto each light-receiving surface electrode 2a.

If a plurality of through hole electrodes 2b are provided on one light-receiving surface electrode 2a, a current density per one through hole electrode 2b can be reduced, and thus a resistance in the entire solar cell element 1 can be reduced.

Electrodes formed on the second surface 1a correspond to these electrodes of the first surface 1b, in the following manner. As shown in FIG. 1(a), firstly, a plurality of first electrodes 2 each having a rectangular shape and each electrically connected to the through hole electrode 2b are arranged in straight lines immediately below the through hole electrodes 2b and substantially at regular intervals. One first electrode 2 is connected to one or more of the through hole electrodes 2b.

Moreover, second electrodes 3 of the polarity different from that of the first electrodes 2 are provided. The second electrodes 3 include a collector electrode 3a and output electrodes 3b. That is, the collector electrode 3a is arranged in a portion other than the first electrodes 2 arranged in straight lines and therearound, and the output electrodes 3b are formed on the collector electrode 3a. Each of the output electrodes 3b serves as an electrode for extracting an output of the collector electrode 3a.

The semiconductor substrate 5 has one conductive type. As shown in FIG. 2(a) and (b), the semiconductor substrate 5 includes, on the first surface 1b and the second surface 1a, an opposite-conductive-type semiconductor layer 6 (a first opposite-conductive-type layer 6a and a third opposite-conductive-type layer 6c) having the conductive type different from that of the semiconductor substrate 5.

A second opposite-conductive-type layer 6b is provided on an inner surface of the electrode through hole 8 of the semiconductor substrate 5.

In a case where a silicon substrate of P-type is adopted as the semiconductor substrate 5 of one conductive type, the opposite-conductive-type layer 6 is of N-type, and the opposite-conductive-type layer 6 is formed by diffusing an N-type impurity such as phosphorus in a surface of the semiconductor substrate 5 and an inner surface of the electrode through hole 8.

In FIG. 2(a) and (b), particularly, in a case where aluminum is adopted as an electrode material of the collector electrode 3a, a high-concentration doped layer 10 can be formed simultaneously with the formation of the collector electrode 3a by applying and baking the aluminum. This enables carriers generated in the semiconductor substrate 5 to be efficiently collected. Here, the high concentration means having a higher impurity concentration than a concentration of the one conductive type impurity in the semiconductor substrate 1.

In this manner, in the solar cell element 1 according to the present invention, the light-receiving surface electrodes 2a are provided on the first surface 1b, and the through hole electrodes 2b are provided within the electrode through holes 8. On the second surface 1a, the first electrodes 2 are provided on the opposite-conductive-type semiconductor layer 6, and the collector electrode 3a and the output electrodes 3b serving as the second electrode 3 are provided in a region where the opposite-conductive-type semiconductor layer 6 is not formed.

In order to electrically separate (PN junction isolation) the one conductive type (for example, P-type) from the opposite-conductive-type layer (for example, N-type) of the semiconductor substrate 5, as shown in FIG. 1(a), a separation groove 9a is provided around each first electrode 2 in a surrounding manner, and furthermore a separation groove 9b is provided in a peripheral portion of the second surface 1a of the semiconductor substrate 5.

Hereinafter, one embodiment of the solar cell element of the present invention will be described in detail.

One embodiment of the solar cell element of the present invention is a solar cell element comprising a semiconductor substrate including a first surface serving as a light-receiving surface, a second surface that is a back surface of the first surface, and a plurality of through holes formed so as to extend from the first surface to the second surface. An area of an opening of each of the plurality of through holes increases as the through hole is located closer to a peripheral portion of the semiconductor substrate relative to a central portion thereof.

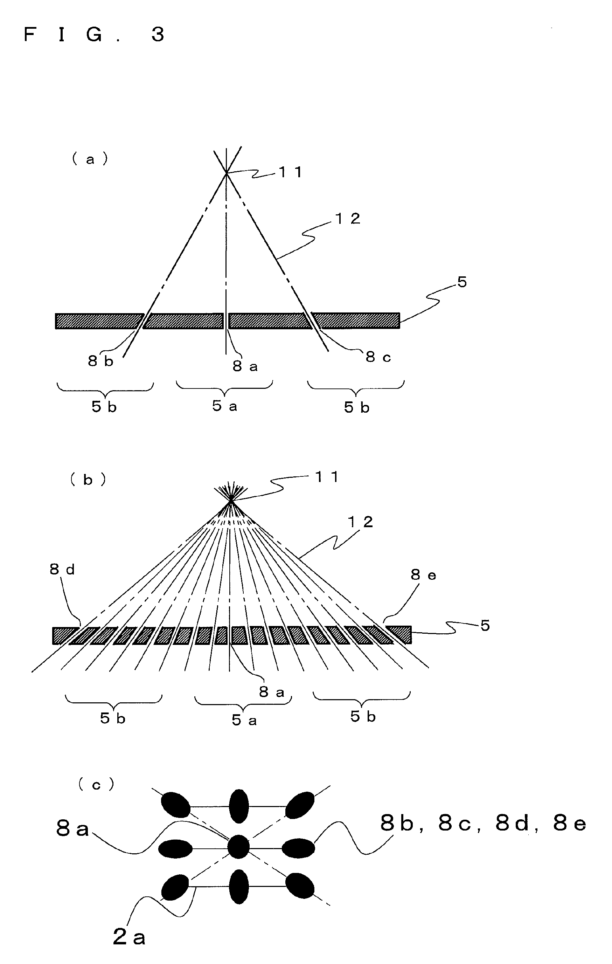

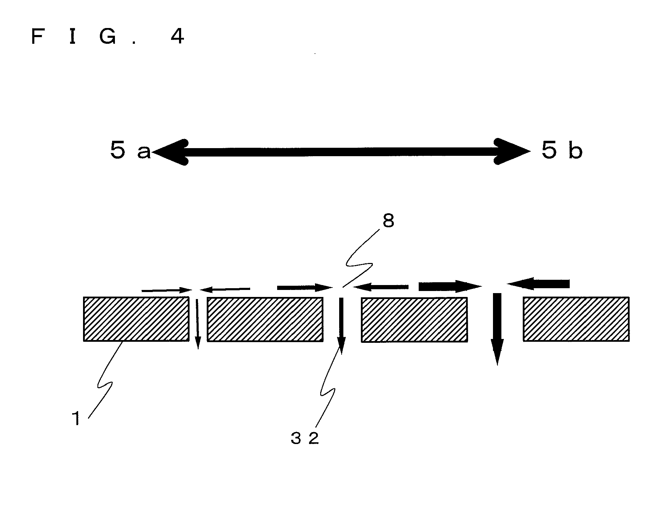

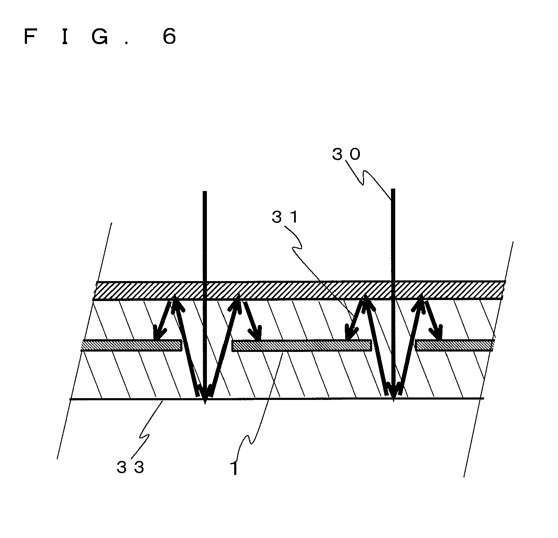

Therefore, a larger hole diameter is given to the through hole 8 located closer to the outer edge of the solar cell element 1, and thereby a difference in the resistance among the through holes 8 can be substantially reduced. Thus, although, as shown in FIG. 4, a density of a current 32 increases toward the outer edge of the solar cell element 1 because of multiple-reflection lights as shown in FIG. 6, the through hole 8 located closer to the outer edge has a larger hole diameter. As a result, as shown in FIG. 3, current densities in the electrodes in the central portion 5a and in the peripheral portion 5b can be made uniform. This can reduce a series resistance component of the entire solar cell element 1, and thus improve a photoelectric conversion efficiency.

Here, although the through hole 8 of the solar cell element 1 includes the conductive load material loaded therein so that the through hole electrode 2b is formed, it is expressed as the through hole 8 for the sake of convenience. From the viewpoint of stabilization of conduction between the first surface 1b and the second surface 1a, it is preferable that the area of the opening of the through hole 8 in the first surface 1b is equal to the area of the opening thereof in the second surface 1a. It is preferable that the cross-section of the through hole 8 parallel to the first surface 1b and the second surface 1a is constant, because it can prevent the through hole 8 from including a narrowed portion, which may otherwise increase the resistance.

In one embodiment of the solar cell element of the present invention, an angle formed between a center line of each of the plurality of through holes and the first surface decreases as the through hole is located closer to the peripheral portion of the semiconductor substrate relative to the central portion thereof.

In one embodiment of the solar cell element of the present invention, extended lines of the center lines of the plurality of through holes converge to a intersection point located at the first surface side.

In one embodiment of the solar cell element of the present invention, the first surface of the semiconductor substrate has a quadrangular shape, and the intersection point is located on a perpendicular line that is perpendicular to the semiconductor substrate and that passes through an intersection between diagonal lines of the semiconductor substrate.

For example, as shown in FIG. 3, it is found that an inclination of each of the plurality of through holes 8 increases as the through hole 8 is located closer to the peripheral portion 5b of the semiconductor substrate 5 relative to the central portion 5a thereof. Moreover, it is found that the center lines 12 of the electrode through holes 8 converge to and intersect one another at one point 11 that is located in a space at the first surface 1b side of the semiconductor substrate 5. Furthermore, it is found that a line segment connecting the one point 11 at the first surface 1b side to an intersection 11 a between the diagonal lines of the semiconductor substrate 5 serves as the perpendicular line to the semiconductor substrate 5.

A length of the through hole 8 extending from the first surface 1b to the second surface 1a can be made larger as the through hole 8 is located closer to the peripheral portion 5b of the semiconductor substrate 5 relative to the central portion 5a thereof.

As a result, the corrosion of the entire through hole 8 due to entry of moisture or the like from the peripheral portion 5b of the solar cell element 1 can be more reduced in a location closer to the peripheral portion 8. Alternatively, though not shown, the same effects as those of the present application can be obtained in a case where the through hole 8 is inclined in the opposite direction.

In one embodiment of the solar cell element of the present invention, the plurality of through holes include first through holes located in the central portion and second through holes located closer to the peripheral portion side than the first through holes, each of the first through holes having the opening with a circular shape, each of the second through holes having the opening with an elliptical shape.

For example, as shown in FIG. 3(c), a first through hole 8a is located at the central portion 5a side, and second through holes 8b, 8c, 8d, and 8e are located closer to the peripheral portion 5b side than the first through hole.

The electrode through hole 8 having an elliptical shape has an increased opening area, which enhances a current collecting effect.

In one embodiment of the solar cell element of the present invention, the second through holes are located radially from the first through hole.

As a result, the corrosion of the entire length of the elliptical opening in a longitudinal direction due to entry of moisture or the like from the peripheral portion 5b of the solar cell element 1 can be more reduced in a location closer to the peripheral portion 8.

In one embodiment of the solar cell element of the present invention, it is preferable that the semiconductor substrate has one conductive type, and an opposite-conductive-type semiconductor layer is formed at an inner side surface of the through hole.

Since the opposite-conductive-type layer 6b is formed at an inner wall of the through hole 8, a leakage current at this portion can be suppressed.

In one embodiment of the solar cell element of the present invention, the inner side surface of the through hole has a larger surface roughness than that of the first surface and the second surface.

This roughened surface increases an area for contact with the conductive load material, and thus the intensity of bonding therebetween can be improved. Additionally, this etching can remove a damaged layer that has occurred in cutting out of a silicon ingot mentioned above, and moreover can roughen the first surface 1b, too. Therefore, reflection of light incident on the solar cell element 1 can be suppressed, and the photoelectric conversion efficiency thereof can be further improved.

### «Method for Manufacturing Solar Cell Element»

Next, a method for manufacturing the solar cell element according to the present invention will be described.

### <Step of Preparing Semiconductor Substrate>

Firstly, as the semiconductor substrate 5 having one conductive type, a P-type silicon substrate doped with boron, for example, is prepared. This silicon substrate may be a silicon substrate comprised of a single-crystalline silicon substrate or a poly-crystalline silicon substrate that has been cut out of a silicon ingot. The shape of the silicon substrate may be a square or a rectangle having a side length of about 140 to 180 mm, for example. The thickness of this may be about 150 to 300 µm.

### <Step of Forming Electrode Through Hole>

Then, the electrode through holes 8 are formed to extend between the first surface 1b and the second surface 1a of the semiconductor substrate 5.

The method for manufacturing the solar cell element of the present invention includes a step of forming a plurality of through holes by irradiating the semiconductor substrate with a laser from a specific position while varying an angle of the irradiation.

The electrode through holes 8 are formed, for example, in a direction from the first surface 1b side toward the second surface 1a side of the semiconductor substrate 5, by using mechanical drilling, water-jet machining, a laser apparatus, or the like. Particularly, a laser or the like is preferably used, in order to prevent occurrence of micro-cracking during and after the formation of the electrode through holes 8.

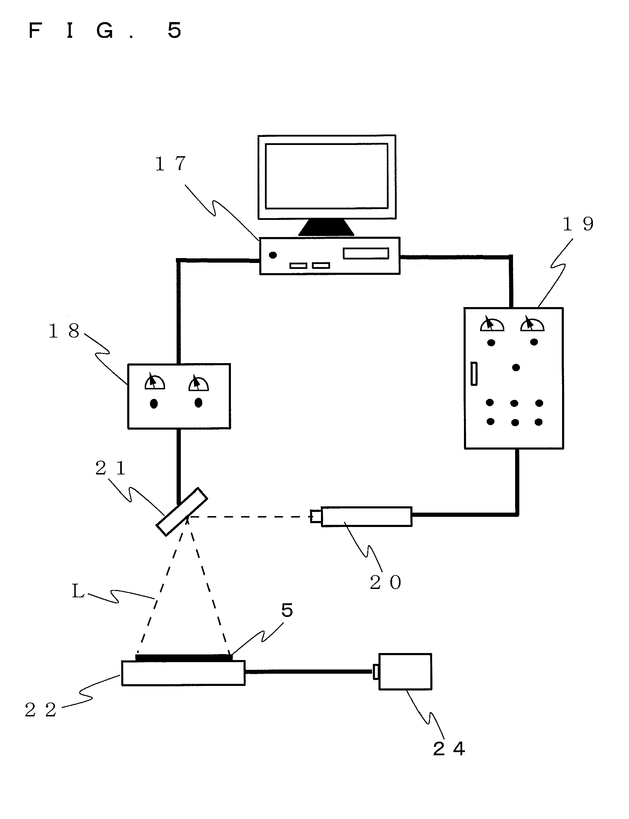

FIG. 5 shows an outline of a laser apparatus that efficiently forms the electrode through holes 8 according to the present invention. The laser apparatus according to the present invention includes an information processing part 17, a laser oscillator part 20, a laser control part 19, a mirror 21, a mirror control section 18, and a mounting table 22. Here, the specific position corresponds to the reference numeral 11 of FIG. 3.

The laser oscillator part 20 has a function to oscillate a laser for melt and removing a part of the semiconductor substrate 5. Examples of the laser include an excimer laser, a YAG (yttrium, aluminum, garnet) laser a YVO₄ (yttrium, vanadate) laser, and the like.

The laser control part 19 controls a laser output and the like. For example, the laser control part 19 controls, adjusts, and stabilizes the laser output and the like, and may include, for example: a power supply circuit for supplying power to the laser oscillator part 20; a temperature sensor, a temperature adjustment circuit, a cooling water passage, and a cooling water tank for detecting and controlling a temperature of the laser oscillator part 20; a filter and a blower for supplying air not containing dust to the laser oscillator part 20 and an optical system; an exhaust duct for removing fume caused by evaporation of the semiconductor substrate 5 due to laser irradiation; an air blowing apparatus for flowing the fume into the duct; a shielding unit for preventing a laser light from leaking to the outside; and a pyroelectric sensor for monitoring a beam output at predetermined time intervals.

The mirror 21 has a function for adjusting a direction (angle) of the laser oscillated by the laser oscillator part 20, and, for example, a galvano mirror is preferably used therefor.

The mirror control section 18 has a function for controlling an angle or the like of the mirror 21 based on information (program) inputted in advance. That is, the mirror control section 18 controls the angle or the like of the mirror 21 so as to irradiate a predetermined position on the semiconductor substrate 5 with the laser.

A convex lens, a flat field lens, an Fθ lens, or the like, may be arranged between the mirror 21 and the semiconductor substrate 5 in order to converge and focus the laser.

The mounting table 22 has a function for supporting the semiconductor substrate 5 on a mounting plane. The mounting table 22 may be configured such that a through hole 8 extending from the mounting plane to a surface opposite to the mounting plane is formed near a central portion of the mounting plane, so that the semiconductor substrate 5 is fixed to the mounting table 22 by using a vacuum pump or the like from the back surface side of the mounting table 19. If a movable mechanism such as a servomotor controlled by a sequencer or the like is attached to the mounting table 22 so that the mounting table 22 can be freely movable in two-axial directions, the semiconductor substrate 5 can be freely transported to, for example, a laser irradiation position and a take-out position for taking out the semiconductor substrate 5. Therefore, the step of forming the electrode through holes 8 can be efficiently performed.

For example, a sequencer is adopted for the information processing part 17, and thereby the information processing part 17 processes information of the mounting table 22 having the semiconductor substrate 5 mounted thereon, the mirror 21, and the laser oscillator part 20, and transmits an instruction to start or complete the formation of the electrode through holes 8 to the laser oscillator part 20 and the mirror control section 18.

Such a laser apparatus enables the electrode through holes 8 having regular inclinations to be efficiently and surely formed.

In the method for manufacturing the solar cell element of the present invention, the specific position is set to be a position at the first surface side and above the semiconductor substrate.

In the method for manufacturing the solar cell element of the present invention, in a case where the first surface of the semiconductor substrate has a quadrangular shape, the specific position is set to be a position above an intersection between the diagonal lines of the first surface of the semiconductor substrate.

This is preferable because it is possible to, without adjusting a laser output, increase the area of the opening of each of the plurality of through holes 8 as the through hole is located closer to the peripheral portion 5b side of the semiconductor substrate 5 relative to the central portion 5a side thereof.
This is preferable also because it is possible to cause the plurality of through holes 8 to extend from the first surface 1b side to the second surface 1a side while inclining in a direction from the central portion 5a side toward the peripheral portion 5b side of the semiconductor substrate 5, and additionally it is possible to increase the inclination of each of the plurality of through holes 8 as the through hole 8 is located closer to the peripheral portion 5b side of the semiconductor substrate 5 relative to the central portion 5a side thereof.

### <Surface Etching>

The semiconductor substrate 5 including the electrode through holes 8 formed therein is etched about 5 to 20 µm with an aqueous solution containing about 10 to 30% of sodium hydroxide at 60 to 90 °C.

As a result, the inner side surface of the electrode through hole 8 is also etched, and a surface thereof is roughened.

### <Step of Forming Opposite-Conductive-Type Layer>

Then, the opposite-conductive-type layer 6 is formed on the surface of the semiconductor substrate 5. P (phosphorus) is adopted as an N-type doping element for forming the opposite-conductive-type layer 6, to form an N⁺ type having a sheet resistance of about 60 to 300 Ω/□. Thereby, a PN junction portion is formed. Further, in a case where, for example, a vapor-phase diffusion process is adopted for forming the opposite-conductive-type layer 6, the opposite-conductive-type layer 6 can be simultaneously formed on both surfaces of the semiconductor substrate 5 and on the inner wall of the electrode through hole 8.

### <Step of Forming Anti-Reflection Coating>

Then, it is preferable to form an anti-reflection coating 7 on the first opposite-conductive-type layer 6a. As a material of the anti-reflection coating 7, a silicone nitride coating, a titanium oxide coating, or the like, may be adopted. As a method for forming the anti-reflection coating 7, a PECVD process, a vapor-deposition process, a sputtering process, or the like, may be adopted.

### <Step of Forming Light-Receiving Surface Electrode and Through Hole Electrode>

Then, the light-receiving surface electrodes 2a and the through hole electrodes 2b are formed on the semiconductor substrate 5. These electrodes can be formed by applying a conductive paste to the first surface 1b of the semiconductor substrate 5 through an application process such as a screen printing method. For example, these electrodes can be formed by baking a conductive paste comprised of silver and the like at a maximum temperature of 500 to 850°C for about several tens of seconds to several tens of minutes.

### <Step of Forming Second Surface Electrode>

Then, the collector electrode 3a is formed on the second surface 1a of the semiconductor substrate 5. For example, a conductive paste can be applied to the second surface 1a of the semiconductor substrate 5 by the screen printing method. For example, a conductive paste comprised of aluminum and the like is applied in a predetermined electrode shape serving as the collector electrode 3a, and baked at a maximum temperature of 500 to 850°C for about several tens of seconds to several tens of minutes. Thereby, the collector electrode 3a is formed. This also enables formation of the high-concentration doped layer 10 having one conductive type semiconductor impurity diffused at a high concentration. Then, the first electrodes 2, the output electrodes 3b, and a third electrode 4 are formed on the second surface 1a of the semiconductor substrate 5.

A conductive paste may be applied to the second surface 1a of the semiconductor substrate 5 through the above-mentioned application process. For example, a conductive paste comprised of silver and the like is applied so as to have an electrode shape shown in FIG. 1(a) by using the screen printing method, and baked at a maximum temperature of 500 to 850°C for about several tens of seconds to several tens of minutes. Thereby, the first electrodes 2, the output electrodes 3b, and the third electrode 4 are formed.

### <Step of Isolation of PN Junction>

PN junction isolation can be performed by a blasting process and a laser machining process. In the blasting process, powdered silicon oxide, powered alumina, or the like, is blasted by high pressure only to the peripheral portion of the second surface 1a, to scrape the opposite-conductive-type layer in the peripheral portion of the second surface 1a. In the laser machining process, the separation groove 9b is formed at a peripheral end portion of the second surface 1a.

Then, in a case of performing PN junction isolation at a peripheral portion of each first electrode 2, a region other than the first electrodes 2, the collector electrode 3a, and the third electrode 4 is irradiated with a laser light by using a YAG laser (wavelength 1064 nm), an SH (second harmonic eneration)-YAG laser (wavelength 532nm), or the like, to thereby form a rectangular separation groove 9a.

### DESCRIPTION OF THE REFERENCE NUMERALS

1: solar cell element
   1a: second surface (back surface, non-light-receiving surface)
   1b: first surface (surface, light-receiving surface)
2: first electrode
   2a: light-receiving surface electrode
   2b: through hole electrode
3: second electrode
   3a: collector electrode
   3b: output electrode
4: third electrode
5: semiconductor substrate
   5a: central portion
   5b: peripheral portion
6: opposite conductive type (semiconductor) layer
   6a: first opposite-conductive-type layer
   6b: second opposite-conductive-type layer
   6c: third opposite-conductive-type layer
7: anti-reflection coating
8: (electrode) through hole
   8a: first through hole
   8b, 8c, 8d, 8e: second through hole
9: dividing groove
   9a: separation groove in peripheral portion
   9b: separation groove in outer peripheral end portion
10: high-concentration doped layer
11: one point (specific position)
   11a: intersection (between diagonal lines)
12: center line (extended line)
17: information processing part
18: mirror control section
19: laser control part
20: laser oscillator part
21: mirror
22: mounting table
23: operation stage
24: step motor
30: incident light
31: multiple-reflection light
32: current
33: back sheet
L: optical path

## Claims

1. A solar cell element, comprising:
a semiconductor substrate with a first surface serving as a light-receiving surface, a second surface that is a back surface of the first surface, and a plurality of through holes formed so as to extend from the first surface to the second surface, wherein
an area of an opening of each of the plurality of through holes increases as the through hole is located closer to a peripheral portion of the semiconductor substrate relative to a central portion thereof.

2. The solar cell element according to claim 1, wherein
an angle formed between a center line of each of the plurality of through holes and the first surface decreases as the through hole is located closer to the peripheral portion of the semiconductor substrate relative to the central portion thereof.

3. The solar cell element according to claim 1 or 2, wherein
extended lines of center lines of the plurality of through holes converge to an intersection point at which the extended lines intersect one another, the intersection point being located at the first surface side.

4. The solar cell element according to claim 3, wherein
the first surface of the semiconductor substrate has a quadrangular shape,
the intersection point is located on a perpendicular line that is perpendicular to the semiconductor substrate and that passes through an intersection between diagonal lines of the semiconductor substrate.

5. The solar cell element according to any one of claims 1 to 4, wherein
the plurality of through holes include a first through hole located in the central portion and second through holes located closer to a peripheral portion side than the first through hole, the opening of the first through hole having a circular shape, the opening of the second through hole having an elliptical shape.

6. The solar cell element according to claim 5, wherein
the second through holes are located radially from the first through hole.

7. The solar cell element according to any one of claims 1 to 6, wherein
the semiconductor substrate has one conductive type, and an opposite-conductive-type semiconductor layer is formed at an inner side surface of the through hole.

8. The solar cell element according to any one of claims 1 to 7, wherein
the inner side surface of the through hole has a larger surface roughness than that of the first surface and the second surface.

9. A solar cell module including the solar cell element according to any one of claims 1 to 8.

10. A method for manufacturing the solar cell element according to any one of claims 1 to 8, the method comprising:
forming the plurality of through holes by irradiating the semiconductor substrate with a laser from a specific position while varying an angle of the irradiation.

11. The method for manufacturing the solar cell element according to claim 10, wherein
the specific position is set to be a position at the first surface side and above the semiconductor substrate.

12. The method for manufacturing the solar cell element according to claim 10 or 11, wherein
in a case where the first surface of the semiconductor substrate has a quadrangular shape, the specific position is set to be a position above an intersection between diagonal lines of the first surface of the semiconductor substrate.
